# EUROPEAN PATENT APPLICATION

(11) **EP 4 756 073 A1**
(43) Date of publication of application: **10.06.2026**
(21) Application number: 24861818.3
(22) Date of filing: 20.08.2024
(51) Int. Cl.: C23C 16/52, H10P 72/00, H10F 71/00

(54) **SEMICONDUCTOR PROCESS CHAMBER AND SEMICONDUCTOR PROCESS DEVICE**

(30) Priority: 04.09.2023 CN 202311132514
(71) Applicant: Beijing NAURA Microelectronics Equipment Co., Ltd., Beijing 100176 (CN)
(72) Inventor: ZHAO, Qingfeng, Beijing 100176 (CN); WANG, Xiaofei, Beijing 100176 (CN); YAN, Jiwei, Beijing 100176 (CN); WANG, Fan, Beijing 100176 (CN)
(74) Representative: Cohausz & Florack
(86) International application number: PCT/CN2024/113276
(87) International publication number: WO 2025/050974

(57) **Abstract**

This application discloses a semiconductor process chamber and semiconductor process equipment. The semiconductor process chamber includes: a chamber body provided with an exhaust port; at least one first flow equalization plate disposed within the chamber body at a side close to the exhaust port and shielding the exhaust port, each first flow equalization plate being provided with a plurality of flow equalization holes; and a connection assembly connecting the chamber body and the first flow equalization plate, wherein the connection assembly is configured such that a distance between at least one first flow equalization plate and the exhaust port is adjustable. Embodiments of his application can maintain, as much as possible, a distance between quartz boats close to the exhaust port and the adjustable first flow equalization plate unchanged, thereby improving film thickness uniformity of silicon wafers in the quartz boats close to the exhaust port. **In** addition, by changing a number of first flow equalization plates, spacing between the first flow equalization plates, and a distance between the first flow equalization plates and the exhaust port, film thickness uniformity of silicon wafers in the quartz boats close to the exhaust port may be improved.

## Description

### TECHNICAL FIELD

This application relates to the field of semiconductor technology, and more particularly to a semiconductor process chamber and semiconductor process equipment.

### BACKGROUND

With the development of the photovoltaic industry, the performance requirements for solar cells increase, and new preparation methods for solar cell are emerging and becoming mature. For example, a horizontal semiconductor process furnace may be used to deposit a thin film on a solar cell (silicon wafer).

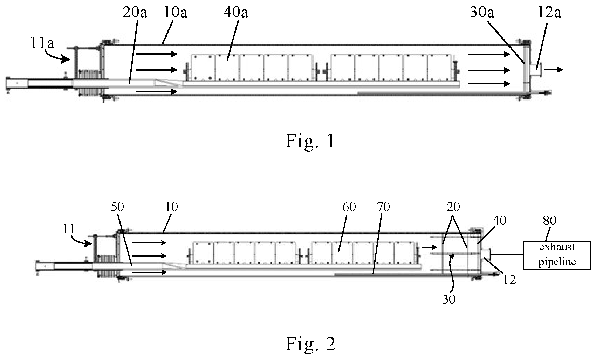

FIG. 1 is a schematic structural diagram of a conventional horizontal semiconductor process chamber. The horizontal semiconductor process chamber includes a chamber body 10a, a carrier 20a, and a flow equalization plate 30a. The chamber body 10a is provided with a gas inlet 11a and an exhaust port 12a. The flow equalization plate 30a is disposed within the chamber body 10a at one end close to the exhaust port 12a.

During processing, silicon wafers are placed in quartz boats 40a and are loaded into the chamber body 10a by the carrier 20a. In FIG. 1, the carrier 20a carries ten quartz boats 40a. Process gas enters through the gas inlet 11a, and exhaust is performed through the exhaust port 12a. The process gas is deposited at high temperature on the surfaces of the silicon wafers to form a thin film. The flow equalization plate 30a can improve gas uniformity in the region of the chamber body 10a close to the exhaust port 12a, thereby improving uniformity of the thin film deposited on the silicon wafers.

With increases in production capacity (i.e., an increase in the number of quartz boats 40a carried during a single process) and increases in the diameter of the chamber body 10a, non-uniform airflow distribution in the region of the chamber body 10a close to the exhaust port 12a may occur, resulting in non-uniform film thickness on the silicon wafers in the quartz boats 40a close to the exhaust port 12a.

### SUMMARY

In view of the above technical problem, this application provides a semiconductor process chamber and semiconductor process equipment, which can improve the problem in existing semiconductor process chambers in which non-uniform airflow distribution is likely to occur in a region close to the exhaust port, thereby resulting in relatively poor film thickness uniformity of thin films deposited on silicon wafers in quartz boats close to the exhaust port.

To solve the above technical problem, in a first aspect, embodiments of this application provide a semiconductor process chamber, including:
a chamber body, wherein the chamber body is provided with an exhaust port;
at least one first flow equalization plate, disposed within the chamber body at a side close to the exhaust port and configured to shield the exhaust port, each first flow equalization plate being provided with a plurality of flow equalization holes;
and a connection assembly, connecting the chamber body and the first flow equalization plate, wherein the connection assembly is configured such that a distance between at least one of the first flow equalization plates and the exhaust port is adjustable.

In some embodiments, the connection assembly includes at least two sleeve-rod assemblies arranged in parallel, one end of each sleeve-rod assembly being connected to the chamber body;
the first flow equalization plate is provided with first through holes in one-to-one correspondence with the sleeve-rod assemblies, the first flow equalization plate being connected to the corresponding sleeve-rod assemblies through the respective first through holes, and a connection position of the first flow equalization plate on the sleeve-rod assemblies being adjustable.

In some embodiments, the sleeve-rod assembly includes:
an inner shaft, one end of which is connected to the chamber body;
a plurality of sleeves sequentially sleeved onto the inner shaft along an axial direction of the inner shaft, the first flow equalization plate being sleeved onto the inner shaft through the corresponding first through hole, and any one of the first flow equalization plates being clamped and fixed between two adjacent sleeves.

In some embodiments, the inner shaft includes:
a connecting sleeve, one end of which is connected to the chamber body, and another end of which is provided with a threaded hole extending along an axial direction of the connecting sleeve;
a screw rod, one end of which is connected to the threaded hole, the plurality of sleeves being freely sleeved onto the screw rod, and the first flow equalization plate being sleeved onto the screw rod through the first through hole;
the sleeve-rod assembly further includes:
   a first nut connected to the other end of the screw rod and configured to fix the first flow equalization plate between the first nut and an end surface of the connecting sleeve when locked in position.

In some embodiments, the sleeve-rod assembly further includes:
a second nut connected to the screw rod and disposed close to an end surface of the threaded hole, the second nut being configured to adjust sleeving positions of the plurality of sleeves on the screw rod and to clamp and fix the plurality of sleeves together with the first nut.

In some embodiments, the semiconductor process chamber further includes:
at least one second flow equalization plate connected to the connection assembly, wherein the at least one first flow equalization plate is located at a side of the second flow equalization plate away from the exhaust port, and the second flow equalization plate is configured to reduce a speed at which gas within the chamber body is exhausted.

In some embodiments, the semiconductor process chamber further includes:
at least one second flow equalization plate disposed close to the exhaust port and connected to the connecting sleeve, the second flow equalization plate being configured to reduce a speed at which gas within the chamber body is exhausted;
two or more first flow equalization plates are provided, and all of the first flow equalization plates are located at a side of the second flow equalization plate away from the exhaust port.

In some embodiments, the second flow equalization plate is provided with flow equalization holes, and a sum of areas of all flow equalization holes on the second flow equalization plate is less than a sum of areas of all flow equalization holes on the first flow equalization plate; or
the second flow equalization plate is not provided with flow equalization holes.

In some embodiments, a number of the flow equalization holes provided on the second flow equalization plate is less than a number of the flow equalization holes provided on the first flow equalization plate, and an area of each flow equalization hole provided on the second flow equalization plate is equal to an area of each flow equalization hole provided on the first flow equalization plate; or
a number of the flow equalization holes provided on the second flow equalization plate is equal to a number of the flow equalization holes provided on the first flow equalization plate, and an area of each flow equalization hole provided on the second flow equalization plate is less than an area of each flow equalization hole provided on the first flow equalization plate; or
a number of the flow equalization holes provided on the second flow equalization plate is less than a number of the flow equalization holes provided on the first flow equalization plate, and an area of each flow equalization hole provided on the second flow equalization plate is less than an area of each flow equalization hole provided on the first flow equalization plate.

In some embodiments, a position of the second flow equalization plate on the connecting sleeve is adjustable.

In some embodiments, the connecting sleeve is provided with an external thread;
the second flow equalization plate is provided with second through holes in one-to-one correspondence with the connecting sleeve, the second flow equalization plate being sleeved onto the connecting sleeve through the second through holes;
the sleeve-rod assembly further includes:
two third nuts connected to the connecting sleeve and located on two sides of the second flow equalization plate, the two third nuts being configured to lock the second flow equalization plate in position after the second flow equalization plate is adjusted to a target position.

In a second aspect, embodiments of this application provide semiconductor process equipment, including the semiconductor process chamber according to any of the foregoing embodiments.

As described above, in the technical solutions of the semiconductor process chamber and the semiconductor process equipment provided in this application, during processing, exhaust is performed through the exhaust port, and the first flow equalization plate can uniformize gas in a region of the chamber body close to the exhaust port. By means of the connection assembly connecting the chamber body and the first flow equalization plate, a distance between at least one first flow equalization plate and the exhaust port is adjustable.

For example, when a relatively large number of quartz boats are carried on the carrier, a position of the adjustable first flow equalization plate may be correspondingly adjusted, for example, adjusted toward the exhaust port, so as to maintain, as much as possible, a distance between the quartz boats close to the exhaust port and the adjustable first flow equalization plate unchanged. That is, even if the number of quartz boats increases, the distance between the quartz boats and the flow equalization plate can be maintained unchanged by correspondingly adjusting the position of the adjustable first flow equalization plate, thereby reducing sudden changes in the deposition environment and improving film thickness uniformity of the silicon wafers in the quartz boats close to the exhaust port.

In addition, in various implementations, different numbers of first flow equalization plates may be provided. By changing the number of first flow equalization plates, spacing between the first flow equalization plates, and the distance between the first flow equalization plates and the exhaust port, film thickness uniformity may be improved.

### BRIEF DESCRIPTION OF THE DRAWINGS

The accompanying drawings are incorporated herein and constitute a part of this specification, illustrate embodiments consistent with this application, and together with the specification serve to explain the principles of this application. In order to more clearly describe the technical solutions of the embodiments of this application, the drawings required for describing the embodiments will be briefly introduced below. It will be apparent that, for those of ordinary skill in the art, other drawings may also be obtained from these drawings without inventive effort.
FIG. 1 is a schematic structural diagram of a conventional horizontal semiconductor process chamber;
FIG. 2 is a schematic structural diagram of a horizontal semiconductor process chamber according to an embodiment of this application;
FIG. 3 is an enlarged schematic structural diagram of a side of the horizontal semiconductor process chamber of FIG. 2 close to the exhaust port;
FIG. 4 is a schematic structural diagram of a flow equalization plate according to an embodiment of this application;
FIG. 5 is a schematic perspective structural diagram of a connection assembly in a connected state according to an embodiment of this application;
FIG. 6 is a partial schematic structural diagram of the connection assembly in the connected state according to an embodiment of this application;
FIG. 7 is an enlarged schematic structural diagram of portion A in FIG. 6;
FIG. 8 is a schematic structural diagram of a conventional flow equalization plate.

The implementation of the objectives, functional features, and advantages of this application will be further described with reference to embodiments and the accompanying drawings. The above drawings illustrate specific embodiments of this application, which will be described in more detail below. These drawings and the written description are not intended to limit the scope of the concepts of this application in any way, but are provided to explain the concepts of this application to those skilled in the art with reference to specific embodiments.

### DETAILED DESCRIPTION

Exemplary embodiments will now be described in detail, examples of which are illustrated in the accompanying drawings. When the following description refers to the drawings, unless otherwise indicated, the same reference numerals in different drawings refer to the same or similar elements. The embodiments described in the following exemplary embodiments do not represent all embodiments consistent with this application. Rather, they are merely examples of devices and methods consistent with certain aspects of this application as recited in the appended claims.

It should be noted that, in this specification, the terms "include," "includes," "including," "comprise," "comprises," "comprising," or any other variations thereof are intended to cover a non-exclusive inclusion, such that a process, method, article, or apparatus that includes a list of elements includes not only those elements but also other elements not expressly listed or inherent to such process, method, article, or apparatus. In the absence of further limitation, an element defined by the phrase "including a ..." does not exclude the presence of additional identical elements in the process, method, article, or apparatus that includes the element. In addition, components, features, or elements having the same names in different embodiments of this application may have the same meanings or may have different meanings, and their specific meanings shall be determined according to their descriptions in the specific embodiments or in combination with the context of the specific embodiments.

It should be further understood that the terms "include," "including," and "comprise" indicate the presence of stated features, steps, operations, elements, components, items, categories, and/or groups, but do not preclude the presence, occurrence, or addition of one or more other features, steps, operations, elements, components, items, categories, and/or groups. The terms "or," "and/or," and "at least one of," as used in this application, are to be interpreted in an inclusive sense, meaning any one or any combination thereof. For example, "at least one of A, B, and C" means any one of: A; B; C; A and B; A and C; B and C; A, B, and C. Similarly, "A, B, or C" or "A, B, and/or C" means any one of: A; B; C; A and B; A and C; B and C; A, B, and C. Exceptions to this definition occur only when a combination of elements, functions, steps, or operations is inherently mutually exclusive in certain ways.

It should be understood that although the terms "first," "second," "third," and the like may be used herein to describe various information, such information should not be limited by these terms. These terms are only used to distinguish information of the same type from one another. For example, without departing from the scope of this application, first information may also be referred to as second information, and similarly, second information may also be referred to as first information. Depending on the context, the singular forms "a," "an," and "the," as used herein, are intended to include the plural forms as well, unless the context clearly indicates otherwise.

It should be understood that terms such as "top," "bottom," "upper," "lower," "vertical," "horizontal," and the like, which indicate orientation or positional relationships, are based on the orientation or positional relationships shown in the drawings, and are used only for convenience of description and simplification of the description. They do not indicate or imply that the referenced device must have a particular orientation, be constructed in a particular orientation, or be operated in a particular orientation, and therefore should not be construed as limiting this application.

For convenience of description, in the following embodiments, a space formed by a horizontal plane and a vertical direction is taken as an example for description. This assumption should not be construed as limiting this application.

As described above, in a conventional horizontal semiconductor process chamber, non-uniform airflow distribution is likely to occur in a region close to the exhaust port 12a, resulting in relatively poor film thickness uniformity of thin films deposited on silicon wafers in quartz boats 40a close to the exhaust port 12a. Experimental testing shows that, in FIG. 1, for silicon wafers in the two quartz boats 40a close to the exhaust port 12a, a thickness difference between a central region and an edge region of the same silicon wafer may reach as high as 12.3%. Film thickness may be characterized by color. Through on-site observation after process testing, silicon wafers in the two quartz boats 40a close to the exhaust port 12a exhibit significant color differences within the same silicon wafer, and significant color differences between different silicon wafers in the same quartz boat 40a are also observed, indicating that both intra-wafer and inter-wafer uniformity in the two quartz boats 40a close to the exhaust port 12a are relatively poor.

After research and analysis, the inventors of this application have found that as the number of quartz boats 40a increases, a distance between the quartz boats 40a and the flow equalization plate 30a correspondingly changes, thereby affecting uniformity of the thin film on the silicon wafers close to the exhaust port 12a. Based on this, this application provides a semiconductor process chamber and semiconductor process equipment. The semiconductor process chamber is not limited to a horizontal semiconductor process chamber, and may also be a vertical semiconductor process chamber. The following description will use a horizontal semiconductor process chamber as an example.

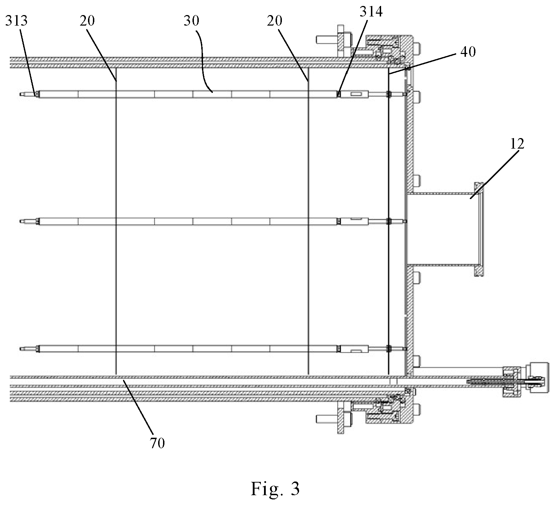

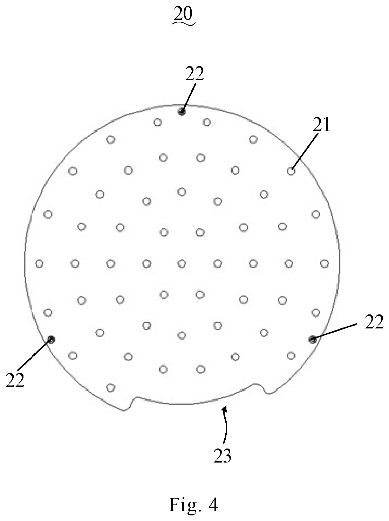

Referring to FIGS. 2-4, FIG. 2 is a schematic structural diagram of a horizontal semiconductor process chamber according to an embodiment of this application; FIG. 3 is an enlarged schematic structural diagram of a side of the horizontal semiconductor process chamber of FIG. 2 close to the exhaust port; and FIG. 4 is a schematic structural diagram of a flow equalization plate according to an embodiment of this application. The horizontal semiconductor process chamber may include a chamber body 10, at least one first flow equalization plate 20, and a connection assembly 30.

The chamber body 10 is provided with an exhaust port 12. In addition, the chamber body 10 is further provided with a gas inlet 11 for introducing process gas into the chamber body 10. The position of the gas inlet 11 is not particularly limited in the embodiments of this application. In some embodiments, the gas inlet 11 and the exhaust port 12 are disposed opposite each other on the chamber body 10 to form a more uniform airflow. As an example, the gas inlet 11 may be disposed on a front furnace door of the chamber body 10, and the exhaust port 12 may be disposed on a rear furnace door of the chamber body 10.

In addition, a carrier 50 may be provided. The carrier 50 may carry quartz boats 60 into the chamber body 10 through the front furnace door and may be connected to the chamber body 10 at a side of the gas inlet 11 so as to carry the quartz boats 60 during processing. The carrier 50 may be a silicon carbide paddle.

One, two, or more first flow equalization plates 20 may be provided. The first flow equalization plate 20 is disposed within the chamber body 10 at a side close to the exhaust port 12 and shields the exhaust port 12. Each first flow equalization plate 20 is provided with a plurality of flow equalization holes 21. The connection assembly 30 connects the chamber body 10 and the first flow equalization plate 20. For example, the first flow equalization plate 20 may be connected to the rear furnace door through the connection assembly 30. In addition, the connection assembly 30 is configured such that a distance between at least one first flow equalization plate 20 and the exhaust port 12 is adjustable.

For example, when two first flow equalization plates 20 are provided, the distance between either one of the first flow equalization plates 20 and the exhaust port 12 may be adjustable while the other is fixed; alternatively, both first flow equalization plates 20 may be adjustable. When three first flow equalization plates 20 are provided, the distance between any one of the first flow equalization plates 20 and the exhaust port 12 may be adjustable while the other two are fixed; alternatively, any two of the first flow equalization plates 20 may be adjustable while the remaining one is fixed; alternatively, all three first flow equalization plates 20 may be adjustable. In some embodiments, the first flow equalization plate 20 closest to the quartz boats 60 is adjustable.

During processing, process gas may be introduced through the gas inlet 11, and exhaust may be performed through the exhaust port 12. The first flow equalization plate 20 can uniformize gas in a region of the chamber body 10 close to the exhaust port 12.

By means of the connection assembly 30 connecting the chamber body 10 and the first flow equalization plate 20, a distance between at least one first flow equalization plate 20 and the exhaust port 12 on the connection assembly 30 is adjustable. When a relatively large number of quartz boats 60 are carried on the carrier 50, a position of the adjustable first flow equalization plate 20 may be correspondingly adjusted, for example, adjusted toward the exhaust port 12, so as to maintain, as much as possible, a distance between the quartz boats 60 close to the exhaust port 12 and the adjustable first flow equalization plate 20 unchanged.

That is, even if the number of quartz boats 40a increases, the distance between the quartz boats 40a and the flow equalization plate 30a may be maintained unchanged by correspondingly adjusting the position of the adjustable first flow equalization plate 20, thereby reducing sudden changes in the deposition environment and improving film thickness uniformity of the silicon wafers in the quartz boats 60 close to the exhaust port 12.

It should be noted that the adjustment principle of the first flow equalization plate 20 is not limited to the above adjustment manner. Some adjustable first flow equalization plates 20 may be adjusted toward the exhaust port 12, while other adjustable first flow equalization plates 20 may be adjusted toward the quartz boats 60 (that is, away from the exhaust port 12). Specific adjustment may be performed according to the number of quartz boats 60 and the gas uniformization process effect.

In addition, according to certain conditions, different numbers of first flow equalization plates 20 may be provided. By changing the number of first flow equalization plates 20, spacing between the first flow equalization plates 20, and the distance between the first flow equalization plates 20 and the exhaust port 12, film thickness uniformity may be improved.

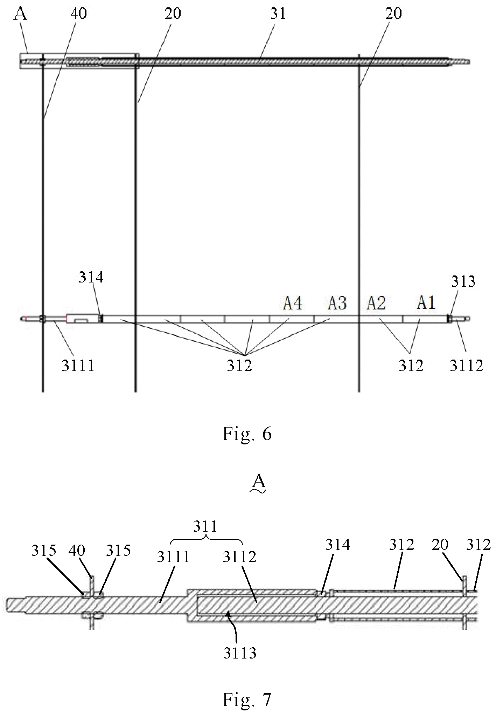

In one embodiment, referring to FIGS. 2-6, FIG. 5 is a schematic perspective structural diagram of a connection assembly in a connected state according to an embodiment of this application, and FIG. 6 is a partial schematic structural diagram of the connection assembly in the connected state according to an embodiment of this application. The connection assembly 30 may include at least two sleeve-rod assemblies 31 arranged in parallel, and one end of each sleeve-rod assembly 31 is connected to the chamber body 10.

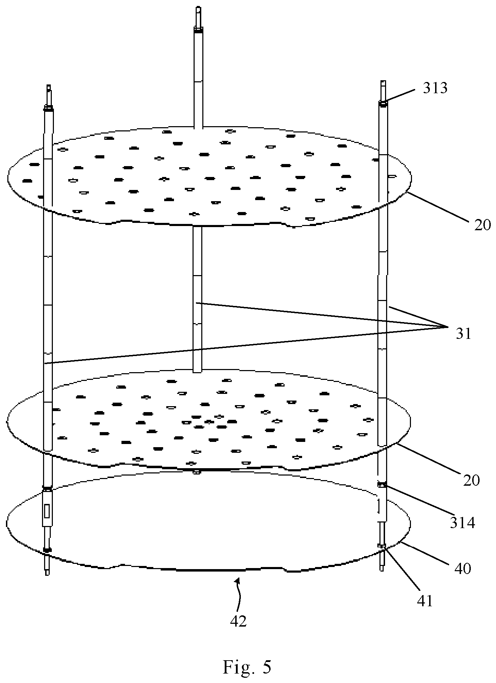

The first flow equalization plate 20 is provided with first through holes 22 in one-to-one correspondence with the sleeve-rod assemblies 31. For example, when the connection assembly 30 includes three sleeve-rod assemblies 31 as shown in FIG. 5, the first flow equalization plate 20 may be provided with three first through holes 22 as shown in FIG. 4. The first flow equalization plate 20 is connected to the corresponding sleeve-rod assemblies 31 through the respective first through holes 22, and a connection position of the first flow equalization plate 20 on the sleeve-rod assemblies 31 is adjustable, for example, the first flow equalization plate 20 may slide toward the exhaust port 12 or away from the exhaust port 12.

**In** this embodiment, the first flow equalization plate 20 is connected to the chamber body 10 through at least two sleeve-rod assemblies 31 arranged in parallel, and the connection position of the first flow equalization plate 20 on the sleeve-rod assemblies 31 is adjustable. Therefore, the gas uniformization effect may be adjusted according to specific process requirements, so as to improve film thickness uniformity of the silicon wafers at the side close to the exhaust port 12.

As an example, referring to FIGS. 6 and 7, FIG. 7 is an enlarged schematic structural diagram of portion A in FIG. 6. The sleeve-rod assembly 31 may include an inner shaft 311 and a plurality of sleeves 312. One end of the inner shaft 311 is connected to the chamber body 10. For example, a threaded structure may be provided, and the inner shaft 311 may be fixed to the rear furnace door of the chamber body 10 by bolts.

The plurality of sleeves 312 are sequentially sleeved onto the inner shaft 311 along an axial direction of the inner shaft 311. The first flow equalization plate 20 is sleeved onto the inner shaft 311 through the corresponding first through hole 22, and any one first flow equalization plate 20 is clamped and fixed between two adjacent sleeves 312.

The specific fixing manner is not particularly limited in this embodiment. For example, the inner shaft 311 may be a screw rod, or may be a smooth shaft with external threads provided only near two ends. Correspondingly, two nuts may be provided to lock all sleeves 312 from an outer side of a first sleeve 312 and an outer side of a last sleeve 312, such that the first flow equalization plate 20 is clamped and fixed between the sleeves 312 on left and right sides.

As shown in FIG. 6, among the sleeves 312 arranged sequentially from right to left, four sleeves 312 closest to the right side are respectively located at a first position A1, a second position A2, a third position A3, and a fourth position A4. Taking as an example that one first flow equalization plate 20 is clamped between two sleeves 312 respectively located at the second position A2 and the third position A3 as shown in FIG. 6, when it is necessary to adjust the first flow equalization plate 20 toward the left according to process requirements, the three sleeves 312 respectively located at the first position A1, the second position A2, and the third position A3, together with the first flow equalization plate 20, may be removed. During reassembly of these removed components, the first flow equalization plate 20 may be assembled between the two sleeves 312 respectively located at the third position A3 and the fourth position A4.

In this embodiment, the structural design of the sleeve-rod assembly 31 and the first flow equalization plate 20 is simple and low in cost, and adjustment of the position of the first flow equalization plate 20 is convenient.

In a specific embodiment regarding the inner shaft 311, referring further to FIG. 7, the inner shaft 311 may include a connecting sleeve 3111 and a screw rod 3112. One end of the connecting sleeve 3111 is connected to the chamber body 10, and another end is provided with a threaded hole 3113 extending along an axial direction of the connecting sleeve 3111. One end of the screw rod 3112 is connected to the threaded hole 3113, that is, an external thread of the screw rod 3112 is in threaded engagement with the threaded hole 3113.

All sleeves 312 are freely sleeved onto the screw rod 3112. The first flow equalization plate 20 is sleeved onto the screw rod 3112 through the first through hole 22 and is clamped and fixed between two adjacent sleeves 312. The sleeve-rod assembly 31 may further include a first nut 313. Referring to FIGS. 5 and 6, the first nut 313 is connected to another end of the screw rod 3112 and is configured to fix the first flow equalization plate 20 between the first nut 313 and an end surface of the connecting sleeve 3111 when locked in position, and the first flow equalization plate 20 is clamped and fixed between two adjacent sleeves 312.

In some embodiments, referring further to FIGS. 3 and FIGS. 5-7, the sleeve-rod assembly 31 may further include a second nut 314. The second nut 314 is connected to the screw rod 3112 and is disposed close to an end surface of the threaded hole 3113. The second nut 314 is configured to adjust sleeving positions of all sleeves 312 on the screw rod 3112 and to clamp and fix all sleeves 312 together with the first nut 313.

That is, in this embodiment, in addition to adjusting the position of the first flow equalization plate 20 by clamping the first flow equalization plate 20 between different sleeves 312, the positions of all sleeves 312 may also be translated by means of the second nut 314, so as to adjust the position of the first flow equalization plate 20 more precisely.

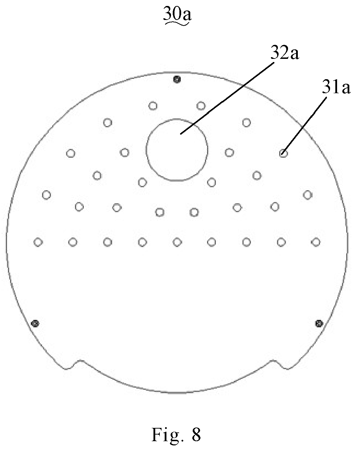

After research and analysis, the inventors of this application have found that, with continuous increases in production capacity, a diameter of the horizontal semiconductor process chamber increases, and process gas is required to remain in the horizontal semiconductor process chamber for a longer gas residence time, so that the process gas may fully react to form a uniform thin film on the silicon wafers. FIG. 8 is a schematic structural diagram of a conventional flow equalization plate. The conventional flow equalization plate 30a is provided with small flow equalization holes 31a and large flow equalization holes 32a. The large flow equalization holes 32a cause the process gas to have an excessively short gas residence time within the horizontal semiconductor process chamber.

Therefore, In some embodiments, the present application eliminates the large flow equalization holes 32a on the conventional flow equalization plate 30a. The flow equalization holes 21 on the first flow equalization plate 20 are all small holes. For example, an aperture diameter may be 0.5 mm-5 mm. In some embodiments, the flow equalization holes 21 are uniformly distributed over the entire first flow equalization plate 20. In addition, two or more first flow equalization plates 20 may be provided to increase gas residence time of the process gas and enhance the gas uniformization effect.

In one embodiment, the present application may further increase gas residence time of the process gas by providing a second flow equalization plate. Referring further to FIGS. 2, 3, and 5-7, the horizontal semiconductor process chamber may further include at least one second flow equalization plate 40. The second flow equalization plate 40 is connected to the connection assembly 30, and the at least one first flow equalization plate 20 is located at a side of the second flow equalization plate 40 away from the exhaust port 12. The second flow equalization plate 40 is configured to reduce a speed at which gas within the chamber body 10 is exhausted.

It may be understood that one or more second flow equalization plates 40 may be provided so as to gradually reduce an exhaust speed. All first flow equalization plates 20 are disposed at a side close to the quartz boats 60, and all second flow equalization plates 40 are disposed at a side close to the exhaust port 12. For example, in FIG. 3, two first flow equalization plates 20 are disposed close to the quartz boats 60 to improve the gas uniformization effect, and one second flow equalization plate 40 is disposed close to the exhaust port 12 to reduce the speed at which gas within the chamber body 10 is exhausted.

In one embodiment, an exhaust area provided on the second flow equalization plate 40 (that is, a total area through which gas passes through the second flow equalization plate 40) is less than a sum of areas of all flow equalization holes 21 on the first flow equalization plate 20. For example, flow equalization holes may be formed on the second flow equalization plate 40. However, compared with the first flow equalization plate 20, a sum of areas of all flow equalization holes on the second flow equalization plate 40 (that is, the above exhaust area) is less than the sum of areas of all flow equalization holes 21 on the first flow equalization plate 20.

In some examples, a number of the flow equalization holes provided on the second flow equalization plate 40 may be less than a number of the flow equalization holes 21 provided on the first flow equalization plate 20, and an area of each flow equalization hole provided on the second flow equalization plate 40 may be equal to an area of each flow equalization hole 21 provided on the first flow equalization plate 20. The area of each flow equalization hole refers to a ventilation cross-sectional area of the flow equalization hole. For example, fewer flow equalization holes having the same aperture diameter as the flow equalization holes 21 may be formed on the second flow equalization plate 40.

Alternatively, a number of the flow equalization holes provided on the second flow equalization plate 40 may be equal to a number of the flow equalization holes 21 provided on the first flow equalization plate 20, and an area of each flow equalization hole provided on the second flow equalization plate 40 may be less than an area of each flow equalization hole 21 provided on the first flow equalization plate 20. For example, flow equalization holes having the same number as the flow equalization holes 21 but having a smaller aperture diameter than the flow equalization holes 21 may be formed on the second flow equalization plate 40.

Alternatively, a number of the flow equalization holes provided on the second flow equalization plate 40 may be less than a number of the flow equalization holes 21 provided on the first flow equalization plate 20, and an area of each flow equalization hole provided on the second flow equalization plate 40 may be less than an area of each flow equalization hole 21 provided on the first flow equalization plate 20. For example, fewer flow equalization holes having a smaller aperture diameter than the flow equalization holes 21 may be formed on the second flow equalization plate 40.

In another embodiment, no flow equalization holes are provided on the second flow equalization plate 40. All of the above embodiments may reduce a speed at which gas within the chamber body 10 is exhausted.

It should be noted that the absence of flow equalization holes on the second flow equalization plate 40 does not completely block airflow. This is because a gap exists between a circumferential edge of the second flow equalization plate 40 and an inner wall of the chamber body 10.

In addition, in order to improve gas uniformity, a gas replenishment pipe 70 may further be provided. Referring to FIG. 2, the gas replenishment pipe 70 may extend into the chamber body 10 from the rear furnace door and extend toward a middle portion of the chamber body 10 to replenish gas. In this case, corresponding indents (23, 42) may be formed on the first flow equalization plate 20 and the second flow equalization plate 40 to avoid interference with the gas replenishment pipe 70. The indents may also serve as gas flow passages during exhaust.

In one embodiment, two or more first flow equalization plates 20 are provided. The second flow equalization plate 40 is disposed close to the exhaust port 12 and is connected to the connecting sleeve 3111 of the inner shaft 311. That is, all first flow equalization plates 20 are disposed at a side close to the quartz boats 60 to improve the gas uniformization effect, and the second flow equalization plate 40 is disposed at a side close to the exhaust port 12 to increase gas residence time of the process gas.

In one embodiment, a position of the second flow equalization plate 40 on the connecting sleeve 3111 is adjustable. A distance between the second flow equalization plate 40 and the quartz boats 60 also affects airflow uniformity. In this embodiment, gas uniformity may be further improved by adjusting the position of the second flow equalization plate 40.

In one example, the position of the second flow equalization plate 40 is adjustable, referring further to FIGS. 5 and 7, the second flow equalization plate 40 is provided with second through holes 41 in one-to-one correspondence with the connecting sleeve 3111. The second flow equalization plate 40 is sleeved onto the connecting sleeve 3111 through the second through holes 41. The connecting sleeve 3111 may be provided with an external thread. The sleeve-rod assembly 31 may further include two third nuts 315. The two third nuts 315 are connected to the connecting sleeve 3111 and are located on two sides of the second flow equalization plate 40, and are configured to lock the second flow equalization plate 40 in position after the second flow equalization plate 40 is adjusted to a target position.

Embodiments of this application further provide semiconductor process equipment. Referring to FIG. 2, the semiconductor process equipment may include the semiconductor process chamber according to the foregoing embodiments.

In some embodiments, the semiconductor process equipment may further include an exhaust pipeline 80 connected to the exhaust port 12.

In some embodiments, the semiconductor process equipment may be a horizontal semiconductor process furnace.

For other working principles and processes of the semiconductor process equipment in this embodiment, reference may be made to the foregoing description of the semiconductor process chamber in the embodiments of this application, and details are not repeated herein.

The semiconductor process chamber and semiconductor process equipment provided by this application have been described above in detail. Specific examples have been used in this specification to illustrate the principles and implementations of this application. It should be noted that, in this application, the descriptions of the various embodiments each have different emphases. For portions not described in detail or not recorded in one embodiment, reference may be made to the relevant descriptions in other embodiments.

The foregoing descriptions are merely embodiments of this application and are not intended to limit the scope of protection of this application. Various technical features of the technical solutions of this application may be combined in any suitable manner. For brevity, not all possible combinations of the technical features in the above embodiments have been described. Any equivalent structures or equivalent process transformations made based on the description and drawings of this application, or directly or indirectly applied in other related technical fields, shall likewise fall within the scope of protection of this application, provided that such combinations of technical features are not contradictory.

## Claims

1. A semiconductor process chamber, comprising:
a chamber body, wherein the chamber body is provided with an exhaust port;
at least one first flow equalization plate disposed within the chamber body at a side close to the exhaust port and shielding the exhaust port, each first flow equalization plate being provided with a plurality of flow equalization holes; and
a connection assembly connecting the chamber body and the first flow equalization plate, wherein the connection assembly is configured such that a distance between at least one first flow equalization plate and the exhaust port is adjustable.

2. The semiconductor process chamber according to claim 1, wherein the connection assembly comprises at least two sleeve-rod assemblies arranged in parallel, one end of each sleeve-rod assembly being connected to the chamber body; and
wherein the first flow equalization plate is provided with first through holes in one-to-one correspondence with the sleeve-rod assemblies, the first flow equalization plate being connected to the corresponding sleeve-rod assemblies through the respective first through holes, and a connection position of the first flow equalization plate on the sleeve-rod assemblies being adjustable.

3. The semiconductor process chamber according to claim 2, wherein each sleeve-rod assembly comprises:
an inner shaft, one end of the inner shaft being connected to the chamber body; and
a plurality of sleeves sequentially sleeved onto the inner shaft along an axial direction of the inner shaft,
wherein the first flow equalization plate is sleeved onto the inner shaft through the corresponding first through hole, and any one first flow equalization plate is clamped and fixed between two adjacent sleeves.

4. The semiconductor process chamber according to claim 3, wherein the inner shaft comprises:
a connecting sleeve, one end of the connecting sleeve being connected to the chamber body and another end the connecting sleeve being provided with a threaded hole extending along an axial direction of the connecting sleeve; and
a screw rod, one end of the screw rod is connected to the threaded hole,
wherein the plurality of sleeves are freely sleeved onto the screw rod, and the first flow equalization plate is sleeved onto the screw rod through the first through hole;
wherein the sleeve-rod assembly further comprises:
a first nut connected to another end of the screw rod and configured to fix the first flow equalization plate between the first nut and an end surface of the connecting sleeve when locked in position.

5. The semiconductor process chamber according to claim 4, wherein the sleeve-rod assembly further comprises:
a second nut connected to the screw rod and disposed close to an end surface of the threaded hole, the second nut being configured to adjust sleeving positions of the plurality of sleeves on the screw rod and to clamp and fix the plurality of sleeves together with the first nut.

6. The semiconductor process chamber according to claim 1, further comprising:
at least one second flow equalization plate connected to the connection assembly,
wherein the at least one first flow equalization plate is located at a side of the second flow equalization plate away from the exhaust port, and
wherein the second flow equalization plate is configured to reduce a speed at which gas within the chamber body is exhausted.

7. The semiconductor process chamber according to claim 4, further comprising:
at least one second flow equalization plate disposed close to the exhaust port and connected to the connecting sleeve, the second flow equalization plate being configured to reduce a speed at which gas within the chamber body is exhausted;
wherein two or more first flow equalization plates are provided, and all of the first flow equalization plates are located at a side of the second flow equalization plate away from the exhaust port.

8. The semiconductor process chamber according to claim 6 or 7, wherein the second flow equalization plate is provided with flow equalization holes, and a sum of areas of all flow equalization holes on the second flow equalization plate is less than a sum of areas of all flow equalization holes on the first flow equalization plate; or
wherein the second flow equalization plate is not provided with flow equalization holes.

9. The semiconductor process chamber according to claim 8, wherein:
a number of the flow equalization holes provided on the second flow equalization plate is less than a number of the flow equalization holes provided on the first flow equalization plate, and an area of each flow equalization hole provided on the second flow equalization plate is equal to an area of each flow equalization hole provided on the first flow equalization plate; or
a number of the flow equalization holes provided on the second flow equalization plate is equal to a number of the flow equalization holes provided on the first flow equalization plate, and an area of each flow equalization hole provided on the second flow equalization plate is less than an area of each flow equalization hole provided on the first flow equalization plate; or
a number of the flow equalization holes provided on the second flow equalization plate is less than a number of the flow equalization holes provided on the first flow equalization plate, and an area of each flow equalization hole provided on the second flow equalization plate is less than an area of each flow equalization hole provided on the first flow equalization plate.

10. The semiconductor process chamber according to claim 7, wherein a position of the second flow equalization plate on the connecting sleeve is adjustable.

11. The semiconductor process chamber according to claim 10, wherein:
the connecting sleeve is provided with an external thread;
the second flow equalization plate is provided with second through holes in one-to-one correspondence with the connecting sleeve, the second flow equalization plate being sleeved onto the connecting sleeve through the second through holes; and
the sleeve-rod assembly further comprises two third nuts connected to the connecting sleeve and located on two sides of the second flow equalization plate, the two third nuts being configured to lock the second flow equalization plate in position after the second flow equalization plate is adjusted to a target position.

12. Semiconductor process equipment, comprising the semiconductor process chamber according to any one of claims 1-11.
